# DEMANDE DE BREVET EUROPEEN

(11) **EP 4 044 252 A1**
(43) Date de publication de la demande: **17.08.2022**
(21) Numéro de dépôt: 22155389.4
(22) Date de dépôt: 07.02.2022
(51) Int. Cl.: H01L 29/778, H01L 29/417, H01L 29/423, H01L 21/336, H01L 29/06, H01L 29/20

(54) **TRANSISTOR**

(30) Priorité: 16.02.2021 FR 2101478
(71) Demandeur: Commissariat à l'Energie Atomique et aux Energies Alternatives, 75015 Paris (FR)
(72) Inventeur: MOHAMAD, Blend, 38054 GRENOBLE CEDEX 09 (FR); ESCOFFIER, René, 38054 GRENOBLE CEDEX 09 (FR)
(74) Mandataire: Cabinet Beaumont

(57) **Abrégé**

La présente description concerne un transistor (300) comportant une couche (104) en nitrure de gallium dans laquelle pénètre partiellement une première électrode (112G) de grille dont :
- un premier flanc (118L, 118R) est revêtu :
d'une première épaisseur (T1) d'un premier matériau isolant (302) et d'un deuxième matériau isolant (304) ; et
d'une deuxième épaisseur (T2) d'un matériau conducteur (306) ; et

- un fond (118B) est revêtu d'une troisième épaisseur (T3), inférieure à la première épaisseur, du premier matériau isolant.

## Description

### Domaine technique

La présente description concerne de façon générale les dispositifs électroniques. La présente description concerne plus particulièrement les transistors à haute mobilité électronique (« High-Electron-Mobility Transistor » - HEMT, en anglais), ou transistors HEMT, normalement bloqués à base de nitrure de gallium (GaN) et les procédés de fabrication de tels transistors.

### Technique antérieure

Des transistors HEMT normalement bloqués à base de nitrure de gallium sont couramment utilisés dans des applications de conversion d'énergie électrique, pour des puissances typiquement comprises entre quelques milliwatts et plusieurs dizaines de watts. Il existe plusieurs types de transistors HEMT normalement bloqués, notamment des transistors HEMT comportant une grille isolée de type métal-isolant-semiconducteur (« Metal-Insulator-Semiconductor » - MIS, en anglais), ou transistors MIS-HEMT. De tels transistors possèdent généralement une forte résistance à l'état passant, ce qui nuit à leurs performances. En outre, ces transistors sont affectés par des problèmes liés à des capacités parasites de grille.

### Résumé de l'invention

Il existe un besoin d'améliorer les transistors à grille isolée et à haute mobilité électronique normalement bloqués à base de nitrure de gallium existants.

Un mode de réalisation pallie tout ou partie des inconvénients des transistors à haute mobilité électronique normalement bloqués à base de nitrure de gallium existants.

Un mode de réalisation prévoit un transistor comportant une couche en nitrure de gallium dans laquelle pénètre partiellement une première électrode de grille dont :
- un premier flanc est revêtu :
   d'une première épaisseur d'un premier matériau isolant et d'un deuxième matériau isolant ; et
   d'une deuxième épaisseur d'un matériau conducteur ; et
- un fond est revêtu d'une troisième épaisseur, inférieure à la première épaisseur, du premier matériau isolant.

Selon un mode de réalisation, le transistor comporte en outre des deuxième et troisième électrodes, situées de part et d'autre de la première électrode et pénétrant partiellement à l'intérieur de la couche en nitrure de gallium, la deuxième électrode étant plus proche de la première électrode que la troisième électrode et le premier flanc étant situé du côté de la deuxième électrode.

Selon un mode de réalisation, le matériau conducteur revêtant le premier flanc se prolonge jusqu'à la deuxième électrode.

Selon un mode de réalisation, le fond de la première électrode est séparé de la couche en nitrure de gallium uniquement par la troisième épaisseur du premier matériau isolant.

Selon un mode de réalisation, un deuxième flanc de la première électrode, opposé au premier flanc, est revêtu du premier matériau isolant, sur une épaisseur égale à la troisième épaisseur.

Selon un mode de réalisation, un deuxième flanc de la première électrode, opposé au premier flanc, est revêtu du premier matériau isolant et du deuxième matériau isolant, sur une épaisseur égale à la première épaisseur.

Selon un mode de réalisation, le deuxième flanc est en outre revêtu du matériau conducteur, sur une épaisseur égale à la deuxième épaisseur.

Selon un mode de réalisation, le matériau conducteur revêtant le deuxième flanc est isolé du matériau conducteur revêtant le premier flanc.

Selon un mode de réalisation, le deuxième matériau isolant est identique au premier matériau isolant.

Selon un mode de réalisation, le deuxième matériau isolant est différent du premier matériau isolant.

Un mode de réalisation prévoit un procédé de fabrication d'un transistor tel que décrit, comprenant les étapes de :
a) former une tranchée à l'intérieur d'une couche en nitrure de gallium ;
b) revêtir un premier flanc de la tranchée d'une couche conductrice puis d'une première couche isolante ;
c) revêtir un fond de la tranchée d'une deuxième couche isolante, moins épaisse que la première couche isolante ; et
d) former une première électrode de grille du transistor à l'intérieur de la tranchée.

Selon un mode de réalisation, à l'étape c), la première couche isolante est revêtue de la deuxième couche isolante.

Selon un mode de réalisation, à l'étape c), un deuxième flanc de la tranchée, opposé au premier flanc, est revêtu de la deuxième couche isolante.

Selon un mode de réalisation, à l'étape b), le deuxième flanc de la tranchée est revêtu de la couche conductrice.

Selon un mode de réalisation, à l'étape b), le deuxième flanc de la tranchée est ensuite revêtu de la première couche isolante.

Selon un mode de réalisation, le procédé comprend en outre, entre les étapes b) et c), l'étape d'éliminer des parties de la première couche isolante et de la couche conductrice situées au fond de la tranchée.

### Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :
la figure 1 est une vue en coupe, schématique et partielle, d'un exemple de transistor ;
la figure 2 est un schéma électrique équivalent au transistor de la figure 1 ;
la figure 3 est une vue en coupe, schématique et partielle, d'un transistor selon un premier mode de réalisation ;
la figure 4 est un schéma électrique équivalent au transistor de la figure 3 ;
la figure 5 est une vue en coupe, schématique et partielle, d'un transistor selon un deuxième mode de réalisation ;
la figure 6 est un schéma électrique équivalent au transistor de la figure 5 ;
la figure 7 est une vue en coupe, schématique et partielle, d'un transistor selon un troisième mode de réalisation ;
la figure 8 est un schéma électrique équivalent au transistor de la figure 7 ;
la figure 9 est une vue en coupe, schématique et partielle, d'un transistor selon un quatrième mode de réalisation ;
la figure 10 est une vue en coupe, schématique et partielle, illustrant une étape d'un mode de mise en œuvre d'un procédé de réalisation du transistor de la figure 9 ;
la figure 11 est une vue en coupe, schématique et partielle, illustrant une autre étape du mode de mise en œuvre du procédé de réalisation du transistor de la figure 9 ;
la figure 12 est une vue en coupe, schématique et partielle, illustrant encore une autre étape du mode de mise en œuvre du procédé de réalisation du transistor de la figure 9 ;
la figure 13 est une vue en coupe, schématique et partielle, illustrant encore une autre étape du mode de mise en œuvre du procédé de réalisation du transistor de la figure 9 ;
la figure 14 est une vue en coupe, schématique et partielle, illustrant encore une autre étape du mode de mise en œuvre du procédé de réalisation du transistor de la figure 9 ; et
la figure 15 est une vue en coupe, schématique et partielle, illustrant encore une autre étape du mode de mise en œuvre du procédé de réalisation du transistor de la figure 9.

### Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, les applications et dispositifs susceptibles de tirer profit des transistors décrits ne sont pas détaillés, les modes de réalisation et modes de mise en œuvre décrits étant compatibles avec les applications et dispositifs usuels comportant des transistors normalement bloqués à haute mobilité électronique à base de nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, sauf précision contraire, les termes isolant et conducteur signifient respectivement électriquement isolant et électriquement conducteur.

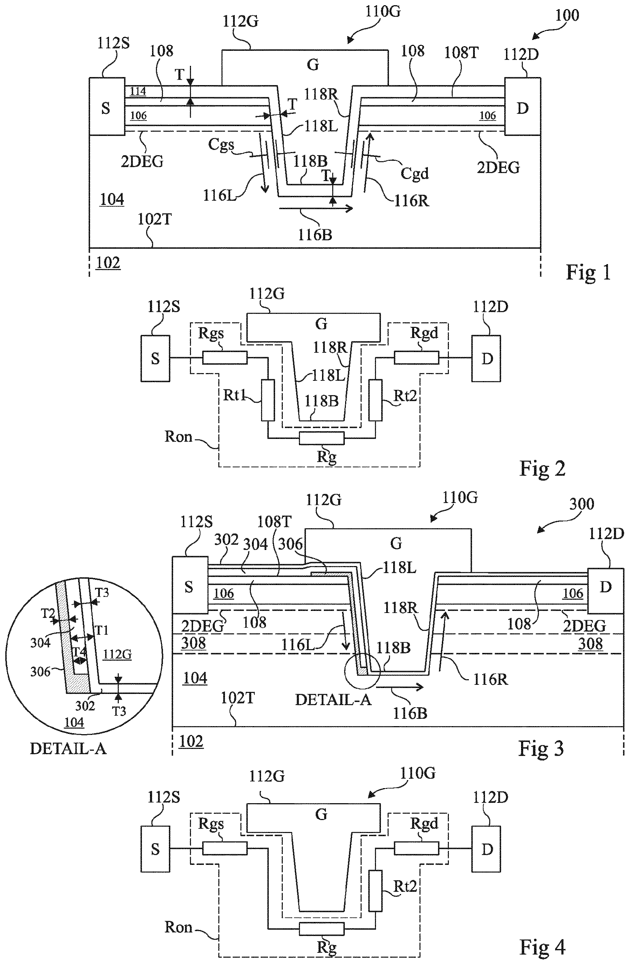

La figure 1 est une vue en coupe, schématique et partielle, d'un exemple de transistor 100 à haute mobilité électronique (« High-Electron-Mobility Transistor » - HEMT, en anglais), ou transistor HEMT. Le transistor HEMT 100 est, dans cet exemple, normalement bloqué.

Dans l'exemple représenté, le transistor HEMT 100 est formé sur un substrat 102. Le substrat 102 est par exemple une plaquette, ou un morceau de plaquette, dont seule une partie est représentée en figure 1. À titre d'exemple, le substrat 102 est en un matériau semiconducteur, par exemple en silicium, ou en verre, en saphir, etc.

Dans l'orientation de la figure 1, une couche 104 revêt une face supérieure 102T du substrat 102. À titre d'exemple, la couche 104 est en nitrure de gallium (GaN), par exemple en nitrure de gallium intrinsèque c'est-à-dire non dopé de manière intentionnelle.

Dans l'exemple représenté, une autre couche 106 revêt une face supérieure de la couche 104. À titre d'exemple, la couche 106 est en nitrure d'aluminium-gallium (AlGaN).

Dans l'exemple représenté, encore une autre couche 108 revêt une face supérieure de la couche 106. À titre d'exemple, la couche 108 est en nitrure de silicium (SiN).

Le transistor 100 comporte une région 110G de grille. La région 110G de grille du transistor 100 est dite encastrée (« recessed », en anglais) dans la couche 104 en nitrure de gallium. Plus précisément, dans l'exemple représenté, la région 110G de grille s'étend verticalement, depuis une face supérieure 108T de la couche 108, en direction de la face supérieure 102T du substrat 102. Chaque couche 106, 108 comporte ainsi deux parties disjointes, situées de part et d'autre de la région 110G de grille.

Dans l'exemple représenté, la région 110G de grille du transistor 100 comporte une électrode 112G de grille (G). L'électrode 112G présente une section en forme de T, dont une portion verticale traverse les couches 108 et 106 et pénètre partiellement dans l'épaisseur de la couche 104. En outre, une portion horizontale du T formé par l'électrode 112G de grille s'étend au-dessus de la couche 108.

Dans l'exemple représenté, les flancs de la portion verticale du T formé par l'électrode 112G de grille sont inclinés de telle sorte qu'ils se rapprochent l'un de l'autre en bas de l'électrode 112G. Cela permet de faciliter le passage des électrons d'un côté à l'autre de l'électrode 112G.

L'électrode 112G de grille est en un matériau conducteur. À titre d'exemple, l'électrode 112G est en un métal ou en un alliage métallique, par exemple un alliage à base de nitrure de titane (TiN) et de tungstène (W).

Dans l'exemple représenté, encore une autre couche 114 isole l'électrode 112G des couches 104, 106 et 108. La couche 114 est en un matériau isolant. À titre d'exemple, la couche 114 est en alumine (Al₂O₃).

La couche isolante 114 revêt les faces latérales et la face inférieure de la portion verticale du T formé par l'électrode 112G. Cette face inférieure est également appelée fond de l'électrode 112G. En outre, la couche isolante 114 se prolonge latéralement de part et d'autre de la portion verticale et sous la portion horizontale du T formé par l'électrode 112G. La couche 114 s'étend sur et en contact avec la face supérieure 108T de la couche 108.

Dans l'exemple représenté, la portion horizontale du T formé par l'électrode 112G s'étend sur et en contact avec des parties de la couche 114. Ces parties de la couche 114 sont ainsi intercalées verticalement entre la couche 108 et la portion horizontale du T formé par l'électrode 112G.

Les parties de la couche 114 situées à l'aplomb de l'électrode 112G de grille sont considérées comme appartenant à la région 110G de grille du transistor 100.

Dans l'exemple représenté, la couche 114 présente une épaisseur T sensiblement constante. À titre d'exemple, l'épaisseur T de la couche 114 est égale à environ 30 nm, à plus ou moins 20 % près. Cela permet d'isoler convenablement l'électrode 112G de grille par rapport à la couche 104 en nitrure de gallium tout en conservant une tension Vth de seuil relativement faible, par exemple de l'ordre de 1 V.

Le transistor 100 comporte en outre deux autres électrodes 112S et 112D. Les électrodes 112S et 112D sont situées de part et d'autre de l'électrode 112G de grille du transistor 100. L'électrode 112S est par exemple plus proche de l'électrode 112G de grille que l'électrode 112D. Les électrodes 112S, 112G et 112D du transistor 100 s'étendent perpendiculairement au plan de coupe de la figure 1, le long d'une direction communément appelée largeur (W) du transistor 100. Le plan de coupe de la figure 1 est ainsi orienté parallèlement à une autre direction communément appelée longueur (L) du transistor 100 et perpendiculairement à la face supérieure 108T de la couche 108.

À titre d'exemple :
- l'électrode 112S est séparée de l'électrode 112G par une distance comprise entre 1 et 2 µm, par exemple égale à environ 1 µm ; et
- l'électrode 112D est séparée de l'électrode 112G par une distance comprise entre 10 et 20 µm, par exemple égale à environ 10 µm, dans le but d'assurer une tenue en tension allant par exemple jusqu'à 1 000 V (le champ électrique maximum dans le GaN est théoriquement de 2 MV/cm, mais il est en pratique limité par exemple à 1 MV/cm par la qualité de la couche 104 en GaN).

Dans l'exemple représenté, les électrodes 112S et 112D s'étendent chacune verticalement, depuis la face supérieure de la couche isolante 114, en direction de la face supérieure 102T du substrat 102. Plus précisément, dans l'exemple représenté, les électrodes 112S et 112D traversent chacune les couches 114, 108 et 106 et pénètrent partiellement dans l'épaisseur de la couche 104.

Les électrodes 112S et 112D sont chacune en un matériau conducteur, par exemple un métal ou un alliage métallique. Les électrodes 112S et 112D sont par exemple en le même matériau que l'électrode 112G.

À titre d'exemple, lorsque le transistor 100 est en fonctionnement, l'électrode 112S est une électrode de source (S) et l'électrode 112D est une électrode de drain (D). L'électrode 112D étant plus éloignée de l'électrode 112G que l'électrode 112S, cela permet d'appliquer un potentiel élevé, par exemple de l'ordre de 650 V, sur l'électrode 112D sans risque de claquage du transistor 100, les électrodes 112S et 112G étant généralement soumises à des potentiels de l'ordre de quelques volts.

Dans le transistor HEMT 100, un gaz d'électrons bidimensionnel (2DEG), symbolisé en figure 1 par un trait en pointillé, se forme à l'intérieur de la couche 104 à proximité d'une interface entre les couches 104 et 106. Les électrodes 112S et 112D du transistor HEMT 100 sont chacune en contact avec le gaz d'électrons bidimensionnel 2DEG.

Dans l'exemple représenté où le transistor HEMT 100 est normalement bloqué, le gaz d'électrons bidimensionnel 2DEG est interrompu par la région 110G de grille. Plus précisément, dans cet exemple, le gaz d'électrons bidimensionnel 2DEG est discontinu et comporte deux parties situées de part et d'autre de la région 110G de grille du transistor 100 (à gauche et à droite de la région 110G, dans l'orientation de la figure 1).

Lorsqu'une tension Vgs sensiblement nulle est appliquée entre l'électrode 112G de grille et l'électrode 112S de source, la région 110G de grille encastrée dans la couche 104 en nitrure de gallium empêche les électrons de circuler entre l'électrode 112S de source et l'électrode 112D de drain. Le transistor 100 est alors dans un état bloqué.

En revanche, lorsque la tension Vgs appliquée entre l'électrode 112G de grille et l'électrode 112S de source excède la tension Vth de seuil du transistor 100, des électrons peuvent circuler entre l'électrode 112S de source et l'électrode 112D de drain. Le transistor 100 est alors dans un état passant.

À l'état passant, les électrons circulent d'une partie à l'autre du gaz d'électrons bidimensionnel 2DEG en contournant la région 110G de grille. Plus précisément, lorsque le transistor 100 est passant et soumis à une tension de polarisation appliquée entre son drain D et sa source S, les électrons empruntent alors, pour circuler d'un côté à l'autre de la grille G, un chemin de conduction situé à l'intérieur de la couche 104 le long d'une interface entre la couche 104 et la couche isolante 114.

Le chemin de conduction emprunté par les électrons pour contourner la région 110G de grille est symbolisé, en figure 1, par des flèches 116L, 116B et 116R. Plus précisément, dans l'orientation de la figure 1 :
- la flèche 116L symbolise un chemin emprunté par les électrons pour descendre le long d'un premier flanc 118L de l'électrode 112G de grille situé côté électrode 112S de source ;
- la flèche 116B symbolise un chemin emprunté par les électrons pour se déplacer horizontalement sous le fond 118B de l'électrode 112G de grille ; et
- la flèche 116R symbolise un chemin emprunté par les électrons pour remonter le long d'un deuxième flanc 118R de l'électrode 112G de grille opposé au flanc 118L, situé côté électrode 112D de drain.

Bien que cela n'ait pas été représenté en figure 1, le transistor 100 peut en outre comporter d'autres éléments tels que des couches isolantes revêtant la couche 114 et/ou une partie de l'électrode 112G de grille, des plaques de champ (« field plates », en anglais), des éléments de reprise de contact, etc.

Un inconvénient des transistors HEMT semblables au transistor 100 tient au fait qu'ils présentent, à l'état passant, une résistance drain-source Ron élevée qui dégrade fortement leurs performances électriques. Cela est notamment dû à des résistances associées aux chemins de conduction 116L, 116B et 116R empruntés par les électrons pour contourner la région 110G de grille.

Afin de diminuer la résistance Ron à l'état passant du transistor 100, on pourrait penser prévoir une structure dans laquelle la couche isolante 114 serait omise et où l'électrode 112G de grille ne pénétrerait pas à l'intérieur de la couche 104 en nitrure de gallium. Cela reviendrait par exemple à faire en sorte que l'électrode 112G s'arrête dans l'épaisseur de la couche 106, avant l'interface entre la couche 106 et la couche 104. On formerait ainsi une grille de type Schottky, qui permettrait d'interrompre ou d'atténuer localement le gaz d'électrons bidimensionnel 2DEG à l'aplomb de l'électrode 112G de grille de sorte à obtenir un transistor normalement bloqué. Toutefois, cela ne permettrait pas d'atteindre une tension Vth de seuil supérieure à environ 1 V, ce qui s'avère problématique pour la plupart des applications utilisant des transistors HEMT.

On pourrait en outre penser réaliser une structure dans laquelle la région 110G de grille ne serait pas encastrée dans les couches 108, 106 et 104. Cela reviendrait par exemple à former l'électrode 112G de grille sur et en contact avec la couche 108. À titre d'exemple, on pourrait notamment prévoir une implantation d'ions fluor (F⁺) dans la couche 106, à l'aplomb de l'électrode 112G de grille, ce qui aurait pour effet d'atténuer ou d'interrompre le gaz d'électrons bidimensionnel 2DEG sous la grille du transistor 100. Cela tendrait toutefois à compliquer un contrôle de la tension Vth de seuil.

On pourrait alternativement prévoir d'omettre la couche 114, de réaliser l'électrode 112G de grille au-dessus de la couche 108 et d'intercaler une couche en nitrure de gallium dopé de type P (p-GaN) entre l'électrode de grille et la couche 108. Toutefois, cela ne permettrait pas d'atteindre une tension Vth de seuil suffisamment élevée pour les applications visées.

On pourrait par ailleurs penser réduire la largeur de la face inférieure 118B de la portion verticale du T formé par la région 110G de grille, de manière à réduire la longueur du chemin de conduction horizontal 116B. Toutefois, cela ne permettrait pas de diminuer significativement la résistance Ron à l'état passant du transistor 100.

Un autre inconvénient des transistors HEMT semblables au transistor 100 tient au fait qu'ils présentent, de part et d'autre de la région 110G de grille, des capacités Cgs et Cgd parasites. La capacité Cgs correspond plus précisément à une capacité parasite entre la partie du gaz d'électrons bidimensionnel 2DEG située du côté de l'électrode 112S de source (la partie gauche du gaz d'électrons bidimensionnel 2DEG, dans l'orientation de la figure 1) et le flanc 118L de l'électrode 112G de grille. La capacité Cgd correspond plus précisément à une autre capacité parasite entre la partie du gaz d'électrons bidimensionnel 2DEG située du côté de l'électrode 112D de drain (la partie droite du gaz d'électrons bidimensionnel 2DEG, dans l'orientation de la figure 1) et le flanc 118R de l'électrode 112G de grille. Les capacités Cgs et Cgd nuisent au fonctionnement du transistor 100 notamment à des fréquences de commutation élevées, par exemple comprises entre une centaine de kilohertz et plusieurs mégahertz.

La figure 2 est un schéma électrique équivalent au transistor 100 de la figure 1.

Comme illustré en figure 2, la résistance Ron à l'état passant du transistor 100, entre sa borne 112S de source et sa borne 112D de drain, peut être décomposée en :
- une résistance Rgs, correspondant à un chemin de conduction empruntant la partie du gaz d'électrons bidimensionnel 2DEG située entre l'électrode 112S de source et l'électrode 112G de grille ;
- une autre résistance Rt1, correspondant au chemin de conduction 116L emprunté par les électrons pour descendre le long du flanc 118L de l'électrode 112G ;
- encore une autre résistance Rg, correspondant au chemin de conduction 116B emprunté par les électrons pour se déplacer horizontalement sous le fond 118B de l'électrode 112G ;
- encore une autre résistance Rt2 correspondant au chemin de conduction 116R emprunté par les électrons pour remonter le long du flanc 118R de l'électrode 112G ; et
- encore une autre résistance Rgd, correspondant à un chemin de conduction empruntant la partie du gaz d'électrons bidimensionnel 2DEG située entre l'électrode 112G de grille et l'électrode 112D de drain.

Les résistances Rgs, Rt1, Rg, Rt2 et Rgd, dont l'association en série équivaut à la résistance Ron (si l'on néglige les résistances de contact ohmique de source et de drain), nuisent au fonctionnement du transistor 100 comme cela a été exposé précédemment en relation avec la figure 1. En particulier, la résistance Rt1 présente généralement une valeur importante, qui modifie la résistance à l'état passant du transistor 100.

La figure 3 est une vue en coupe, schématique et partielle, d'un transistor HEMT 300 normalement bloqué selon un premier mode de réalisation.

Le transistor 300 de la figure 3 comprend des éléments communs avec le transistor 100 de la figure 1. Ces éléments communs ne seront pas décrits à nouveau ci-après. En particulier, le transistor 300 comporte, à l'instar du transistor 100, le substrat 102 dont la face supérieure 102T est revêtue de la couche 104 en nitrure de gallium, de la couche 106 en nitrure d'aluminium-gallium et de la couche 108 en nitrure de silicium. Le transistor 300 comporte en outre la région 110G de grille et les électrodes 112S, 112G et 112D précédemment décrites en relation avec le transistor 100 de la figure 1.

Selon le mode de réalisation illustré en figure 3, le flanc 118L de l'électrode 112G de grille du transistor 300 est revêtu d'une première épaisseur T1 (DETAIL-A) d'un premier matériau isolant 302 et d'un deuxième matériau isolant 304. Le flanc 118L est en outre revêtu d'une deuxième épaisseur T2 d'un matériau conducteur 306. Par ailleurs, le fond 118B de l'électrode 112G du transistor 300 est revêtu d'une troisième épaisseur T3 du premier matériau isolant 302.

Plus précisément, dans l'exemple représenté :
- l'épaisseur T3 du premier matériau isolant 302 s'étend en contact avec l'électrode 112G le long du flanc 118L et du fond 118B ;
- une quatrième épaisseur T4 en deuxième matériau isolant 304 s'étend en contact avec le premier matériau isolant 302 le long du flanc 118L de l'électrode 112G, mais ne s'étend pas le long du fond 118B ; et
- l'épaisseur T2 du matériau conducteur 306 s'étend en contact avec le deuxième matériau isolant 304 le long du flanc 118L de l'électrode 112G, mais ne s'étend pas le long du fond 118B.

L'épaisseur T1 correspond, dans cet exemple, à un cumul de l'épaisseur T3 du premier matériau isolant 302 et de l'épaisseur T4 du deuxième matériau isolant 304 (T1 = T3 + T4). L'épaisseur T1 des matériaux isolants 302 et 304 revêtant le flanc 118L de l'électrode 112G de grille du transistor 300 est donc supérieure à l'épaisseur T3 du matériau isolant 304 revêtant le fond 118B de l'électrode 112G. L'épaisseur T3 du premier matériau isolant 302 est par exemple sensiblement égale à l'épaisseur T de la couche 114 du transistor 100 de la figure 1. À titre d'exemple, l'épaisseur T3 est égale à environ 30 nm, à plus ou moins 20 % près, et l'épaisseur T4 est comprise entre 30 et 100 nm, par exemple égale à 50 nm. L'épaisseur T1 est par exemple comprise entre 60 et 130 nm.

Dans l'exemple représenté, le flanc 118R de l'électrode 112G de grille du transistor 300 est revêtu du premier matériau isolant 302, sur une épaisseur correspondant à la troisième épaisseur T3. Plus précisément, le premier matériau isolant 302, d'épaisseur T3, s'étend en contact avec l'électrode 112G le long du flanc 118R. Dans cet exemple, le premier matériau isolant 302 forme une couche continue revêtant les flancs 118L, 118R et le fond 118B de l'électrode 112G.

Dans l'exemple représenté, le matériau conducteur 306 s'étend sur et en contact avec la face supérieure 108T de la couche 108. Dans cet exemple, le matériau conducteur 306 se prolonge en direction de l'électrode 112S de source à l'aplomb de l'électrode 112G de grille sans contacter l'électrode 112S de source.

À titre d'exemple, l'épaisseur T2 du matériau conducteur 306 est comprise entre 5 et 10 nm.

Le matériau conducteur 306 est par exemple un métal, un alliage métallique ou un semiconducteur dopé de type N. À titre d'exemple, le matériau conducteur 306 est l'aluminium (Al), l'or (Au), le cuivre (Cu) ou le nitrure de titane (TiN).

Dans l'exemple représenté, le transistor 300 comporte en outre une couche 308 barrière arrière (« back barrier », en anglais). La couche 308 permet de compenser des charges négatives piégées au voisinage de la grille, qui tendent à décaler la tension Vth de seuil du transistor 300 vers des valeurs plus faibles. À titre d'exemple, la couche 308 barrière est formée par un dopage de type P de la couche 104. À titre d'exemple, le dopage est réalisé par implantation d'ions magnésium (Mg²⁺) à un taux compris entre 10¹⁷ et 10¹⁸ at./cm³.

Le deuxième matériau isolant 304 est par exemple différent du premier matériau isolant 302. À titre d'exemple, les premier et deuxième matériaux isolants 302, 304 sont choisis chacun parmi l'alumine (Al₂O₃) et la silice (SiO₂).

En variante, le deuxième matériau isolant 304 est identique au premier matériau isolant 302. Dans ce cas, le flanc 118L de l'électrode 112G de grille du transistor 300 est revêtu du premier matériau isolant 302, par exemple l'alumine, sur une épaisseur égale à la première épaisseur T1.

Un avantage du mode de réalisation du transistor 300 exposé en relation avec la figure 3 tient au fait que le matériau conducteur 306 borde le flanc 118L de l'électrode 112G de grille. Cela permet aux électrons de circuler plus facilement autour de la région 110G de grille. Plus précisément, l'épaisseur T2 du matériau conducteur 306 permet aux électrons de descendre plus facilement le long du flanc 118L. Dans le transistor 300, la présence du matériau conducteur 306 le long du flanc 118L de l'électrode 112G permet plus précisément, par rapport au transistor 100 de la figure 1, d'éviter une chute de mobilité due à des états d'interface et à des niveaux de pièges près de l'interface entre la couche 104 et la région 110G de grille.

Le piégeage des électrons se traduit par exemple par un phénomène d'hystérésis, observable par exemple sur des courbes d'évolution d'un courant Id de drain en fonction de la tension Vgs appliquée entre les électrodes 112G de grille et 112S de source (courbes Id(Vgs)). Le piégeage provoque en outre une forte atténuation (« collapse », en anglais) du courant Id de drain après polarisation du transistor 100, observable par exemple sur des courbes du courant Id de drain en fonction d'une tension Vds appliquée entre les électrodes 112D de drain et 112S de source (courbes Id(Vds)). Dans le cas du transistor 300, le phénomène de piégeage des électrons est fortement réduit le long du chemin de conduction 116L car les électrons circulent préférentiellement dans le matériau conducteur 306 plutôt que dans la couche 104.

Un autre avantage de ce mode de réalisation tient au fait que le transistor 300 comporte une surépaisseur de matériau isolant sur le flanc 118L de l'électrode 112G de grille, procurant une isolation plus importante entre l'électrode 112G et la couche 104 par rapport au cas du transistor 100 de la figure 1. Cette surépaisseur est due à la présence du deuxième matériau isolant 304 le long du flanc 118L de l'électrode 112G, le fond 118B étant dépourvu du deuxième matériau isolant 304. Par ailleurs, le fond 118B de l'électrode 112G est séparé de la couche 104 uniquement par l'épaisseur T3 du premier matériau isolant 302. Cela permet de réduire la capacité parasite Cgs du transistor 300 d'environ 15 à 30 % par rapport à un transistor 300 dont le flanc 118L serait dépourvu de matériau isolant 304 et d'environ 40 à 45 % par rapport au transistor 100. La tension Vth de seuil est ainsi relativement faible, par exemple de l'ordre de 1 V, et commandée principalement par le fond 118B de l'électrode 112G de grille, contrairement à un cas où le fond 118B de l'électrode 112G du transistor 300 serait revêtu d'une épaisseur de matériau isolant plus importante, par exemple égale à l'épaisseur T1.

La figure 4 est un schéma électrique équivalent au transistor 300 de la figure 3.

Par rapport au transistor 100 de la figure 1, la résistance Rt1 du transistor 300 est sensiblement nulle en raison de la présence du matériau conducteur 306 le long du flanc 118L de l'électrode 112G de grille.

Comme illustré en figure 4, la résistance Ron à l'état passant du transistor 300, entre sa borne 112S de source et sa borne 112D de drain, peut alors être décomposée en :
- la résistance Rgs du chemin de conduction dans la partie du gaz d'électrons bidimensionnel 2DEG située entre l'électrode 112S de source et l'électrode 112G de grille ;
- la résistance Rg du chemin de conduction 116B emprunté par les électrons pour se déplacer le long du fond 118B de l'électrode 112G ;
- la résistance Rt2 du chemin de conduction 116R emprunté par les électrons pour remonter le long du flanc 118R de l'électrode 112G ; et
- la résistance Rgd du chemin de conduction dans la partie du gaz d'électrons bidimensionnel 2DEG située entre l'électrode 112G de grille et l'électrode 112D de drain.

La résistance Ron à l'état passant du transistor 300 est ainsi plus faible que celle du transistor 100. Dans le transistor 100 de la figure 1, les électrons présentent une faible mobilité le long du chemin de conduction 116L. À titre d'exemple, la mobilité des électrons dans le transistor 100, c'est-à-dire en l'absence de matériau conducteur 306, est de l'ordre de 200 cm²/(V.s) le long du chemin de conduction 116L et d'environ 2 000 cm²/(V.s) dans le gaz d'électrons bidimensionnel 2DEG. Le fait de prévoir le matériau conducteur 306 du côté du flanc 118L de l'électrode 112G de grille du transistor 300 permet d'obtenir, le long du chemin de conduction 116L, une mobilité électronique très supérieure à celle du transistor 100, par exemple sensiblement égale à la mobilité dans le gaz d'électrons bidimensionnel 2DEG.

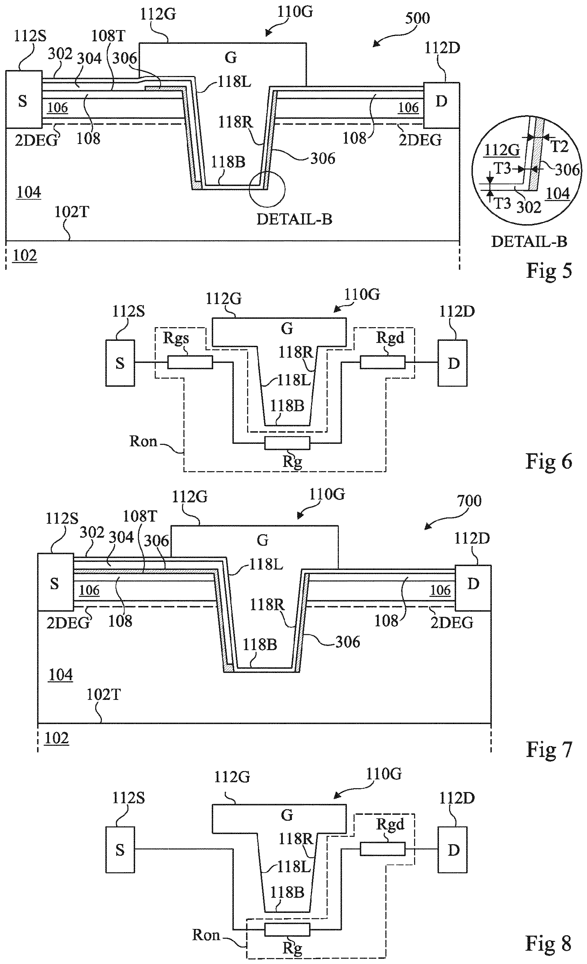

La figure 5 est une vue en coupe, schématique et partielle, d'un transistor 500 selon un deuxième mode de réalisation. Le transistor 500 de la figure 5 comprend des éléments communs avec le transistor 300 de la figure 3. Ces éléments communs ne seront pas décrits à nouveau ci-après.

Le transistor 500 diffère du transistor 300 principalement en ce que le flanc 118R de l'électrode 112G de grille du transistor 500 est en outre revêtu du matériau conducteur 306, sur une épaisseur égale à la deuxième épaisseur T2 (DETAIL-B).

Plus précisément, dans l'exemple représenté :
- l'épaisseur T3 du premier matériau isolant 302 s'étend en contact avec l'électrode 112G le long du flanc 118R ; et
- l'épaisseur T2 du matériau conducteur 306 s'étend en contact avec le premier matériau isolant 302 le long du flanc 118R de l'électrode 112G.

Dans cet exemple, le matériau conducteur 306 forme deux parties de couches disjointes, situées de part et d'autre du fond 118B de l'électrode 112G. Plus précisément, le matériau conducteur 306 situé du côté du flanc 118L est isolé du matériau conducteur 306 situé du côté du flanc 118R.

Dans l'exemple représenté, le transistor 500 est dépourvu de couche 308 barrière arrière.

Un avantage du transistor 500 tient au fait que le matériau conducteur 306 borde le flanc 118R de l'électrode 112G de grille. Cela permet aux électrons de circuler plus facilement autour de la région 110G de grille. Plus précisément, le matériau conducteur 306 permet aux électrons de remonter plus facilement le long du flanc 118R. Dans le transistor 500, la présence du matériau conducteur 306 le long du flanc 118R de l'électrode 112G permet, par rapport au transistor 300 de la figure 3, d'éviter encore davantage la chute de mobilité due aux états d'interface et aux niveaux de pièges près de l'interface entre la couche 104 et la région 110G de grille.

La figure 6 est un schéma électrique équivalent au transistor 500 de la figure 5.

Par rapport au transistor 300 de la figure 3, la résistance Rt2 du transistor 500 est sensiblement nulle en raison de la présence du matériau conducteur 306 le long du flanc 118R de l'électrode 112G de grille.

Comme illustré en figure 6, la résistance Ron à l'état passant du transistor 500, entre sa borne 112S de source et sa borne 112D de drain, peut alors être décomposée en :
- la résistance Rgs du chemin de conduction dans la partie du gaz d'électrons bidimensionnel 2DEG située entre l'électrode 112S de source et l'électrode 112G de grille ;
- la résistance Rg du chemin de conduction 116B emprunté par les électrons pour se déplacer horizontalement sous le fond 118B de l'électrode 112G ; et
- la résistance Rgd du chemin de conduction dans la partie du gaz d'électrons bidimensionnel 2DEG située entre l'électrode 112G de grille et l'électrode 112D de drain.

La résistance Ron à l'état passant du transistor 500 est ainsi encore plus faible que celle du transistor 300. Le fait de prévoir le matériau conducteur 306 du côté du flanc 118R de l'électrode 112G de grille du transistor 500 permet d'obtenir, le long du chemin de conduction 116R, une mobilité électronique par exemple sensiblement égale à la mobilité dans le gaz d'électrons bidimensionnel 2DEG.

La figure 7 est une vue en coupe, schématique et partielle, d'un transistor 700 selon un troisième mode de réalisation. Le transistor 700 de la figure 7 comprend des éléments communs avec le transistor 500 de la figure 5. Ces éléments communs ne seront pas décrits à nouveau ci-après.

Le transistor 700 diffère du transistor 500 principalement en ce que le matériau conducteur 306 situé du côté du flanc 118L de l'électrode 112G du transistor 700 est connecté à l'électrode 112S de source. Plus précisément, la partie de couche du matériau conducteur 306 située du côté du flanc 118L se prolonge, sur et en contact avec la face supérieure 108T de la couche 108, jusqu'à l'électrode 112S. La partie de couche du matériau conducteur 306 située côté flanc 118L présente ainsi, au voisinage du fond 118B de l'électrode 112G, un potentiel sensiblement égal à celui de l'électrode 112S de source, par exemple la masse (0 V).

Un avantage du mode de réalisation du transistor 700 exposé ci-dessus en relation avec la figure 7 tient au fait que le matériau conducteur 306 s'étend depuis l'électrode 112S de source jusqu'au voisinage du fond 118B de l'électrode 112G de grille. Cela permet aux électrons de circuler plus facilement entre l'électrode 112S de source et le fond 118B de l'électrode 112G. Du fait que le matériau conducteur 306 s'étend jusqu'à l'électrode 112S, on obtient notamment un chemin de conduction plus favorable que celui passant par le gaz d'électrons bidimensionnel 2DEG situé dans la couche 104 en nitrure de gallium.

La figure 8 est un schéma électrique équivalent au transistor 700 de la figure 7.

Par rapport au transistor 500 de la figure 5, la résistance Rgs du transistor 700 est sensiblement nulle en raison de la connexion entre le matériau conducteur 306 situé le long du flanc 118L de l'électrode 112G de grille et l'électrode 112S de source. Dans le cas du transistor 700, la prolongation du matériau conducteur 306 jusqu'à l'électrode 112S permet de limiter ou d'éviter des problèmes de contact ohmique entre le gaz d'électrons bidimensionnel 2DEG et le matériau conducteur 306 situé du côté du flanc 118L de l'électrode 112G de grille. Cela permet en outre un meilleur contrôle électrostatique entre grille et source, donc une plus grande efficacité de commande Vgs du transistor 700.

Comme illustré en figure 8, la résistance Ron à l'état passant du transistor 700, entre sa borne 112S de source et sa borne 112D de drain, peut alors être décomposée en :
- la résistance Rg du chemin de conduction 116B (figure 3) emprunté par les électrons pour se déplacer horizontalement sous le fond 118B de l'électrode 112G de grille ; et
- la résistance Rgd du chemin de conduction empruntant la partie du gaz d'électrons bidimensionnel 2DEG située entre l'électrode 112G de grille et l'électrode 112D de drain.

La résistance Ron à l'état passant du transistor 700 est ainsi encore plus faible que celle du transistor 500.

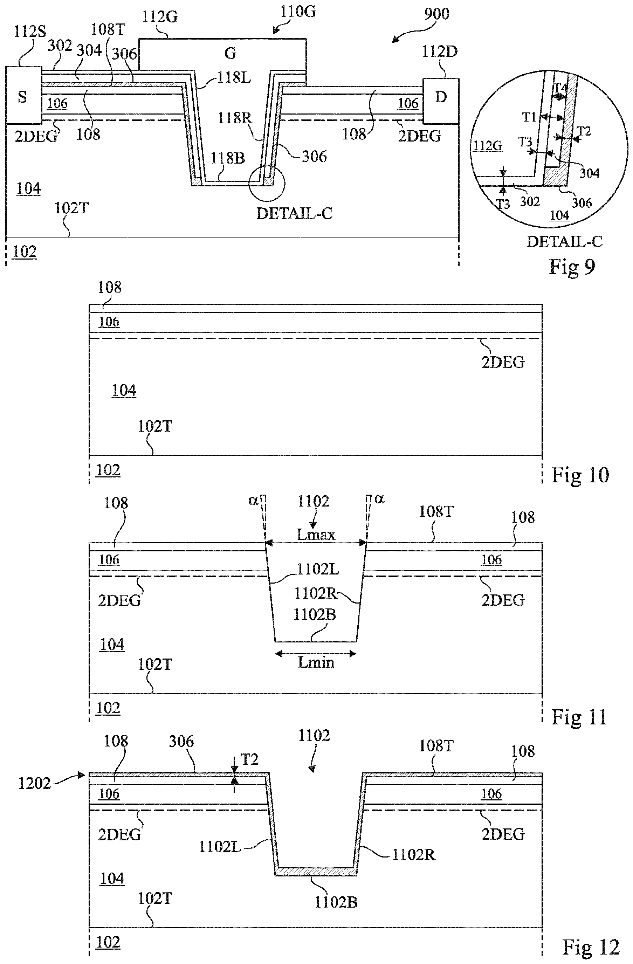

La figure 9 est une vue en coupe, schématique et partielle, d'un transistor 900 selon un quatrième mode de réalisation. Le transistor 900 de la figure 9 comprend des éléments communs avec le transistor 700 de la figure 7. Ces éléments communs ne seront pas décrits à nouveau ci-après.

Le transistor 900 diffère du transistor 700 principalement en ce que le flanc 118R de l'électrode 112G de grille du transistor 900 est revêtu du premier matériau isolant 302, sur une épaisseur correspondant à la troisième épaisseur T3, et du deuxième matériau isolant 304, sur une épaisseur correspondant à la quatrième épaisseur T4 (DETAIL-C). Dit autrement, les premier et deuxième matériaux isolants 302 et 304, dont l'épaisseur cumulée est égale à la première épaisseur T1, revêtent le flanc 118R de l'électrode 112G. Le flanc 118R est en outre revêtu du matériau conducteur 306, sur une épaisseur égale à la deuxième épaisseur T2. Le flanc 118R du transistor 900 est par exemple revêtu de façon analogue au flanc 118L du transistor 700.

Plus précisément, dans l'exemple représenté :
- le premier matériau isolant 302, d'épaisseur T3, s'étend en contact avec l'électrode 112G le long du flanc 118R ;
- le deuxième matériau isolant 304, d'épaisseur T4, s'étend en contact avec le premier matériau isolant 302 le long du flanc 118R de l'électrode 112G ; et
- le matériau conducteur 306, d'épaisseur T2, s'étend en contact avec le deuxième matériau isolant 304 le long du flanc 118R de l'électrode 112G.

Dans cet exemple, le premier matériau isolant 302 forme une couche continue revêtant les flancs 118L, 118R et le fond 118B de l'électrode 112G. En revanche, le deuxième matériau isolant 304 et le matériau conducteur 306 forment chacun deux parties de couches disjointes, situées de part et d'autre du fond 118B de l'électrode 112G. Plus précisément, le matériau conducteur 306 situé du côté du flanc 118L est isolé du matériau conducteur 306 situé du côté du flanc 118R et le matériau isolant 304 situé du côté du flanc 118L est disjoint du matériau isolant 304 situé du côté du flanc 118R.

Dans l'exemple représenté, le matériau conducteur 306, le deuxième matériau isolant 304 et le premier matériau isolant 302 s'étendent horizontalement au-dessus de la face supérieure 108T de la couche 108. Toutefois, le matériau conducteur 306 et les premier et deuxième matériaux isolants 302 et 304 ne se prolongent pas, en direction de l'électrode 112D de drain, au-delà de l'aplomb de l'électrode 112G de grille. Cela permet de maintenir une distance suffisante entre la grille G et le drain D du transistor 300, notamment afin d'éviter tout risque de claquage entre le matériau conducteur 306 situé côté flanc 118R et l'électrode 112D de drain lorsque le transistor 300 est polarisé, par exemple sous une tension égale à environ 650 V.

Un avantage de ce mode de réalisation tient au fait que le transistor 900 comporte une surépaisseur de matériau isolant sur le flanc 118R de l'électrode 112G de grille, procurant une isolation plus importante par rapport au transistor 100 de la figure 1. Cette surépaisseur est due à la présence du deuxième matériau isolant 304 le long du flanc 118R de l'électrode 112G, le fond 118B étant dépourvu du deuxième matériau isolant 304. En outre, le fond 118B de l'électrode 112G est séparé de la couche 104 uniquement par l'épaisseur T3 du premier matériau isolant 302. Cela permet de réduire la capacité parasite Cgd du transistor 900 d'environ 15 à 30 % par rapport à un transistor 900 dont le flanc 118R serait dépourvu de matériau isolant 304 et d'environ 40 à 45 % par rapport au transistor 100. La tension Vth de seuil du transistor 900 est relativement faible, par exemple de l'ordre de 1 V, et commandée principalement par le fond 118B de l'électrode 112G de grille.

Les figures 10 à 15 ci-dessous illustrent des étapes successives d'un exemple d'un mode de mise en œuvre d'un procédé de réalisation du transistor 900 de la figure 9.

La figure 10 est une vue en coupe, schématique et partielle, illustrant une étape du mode de mise en œuvre du procédé de réalisation du transistor de la figure 9.

Au cours de cette étape, la couche 104, la couche 106 et la couche 108 sont successivement réalisées, dans cet ordre, du côté de la face 102T du substrat 102. Plus précisément :
- la couche 104 s'étend de façon continue et sur toute la face 102T supérieure du substrat 102 ;
- la couche 106 s'étend de façon continue et sur toute la face supérieure de la couche 104 ; et
- la couche 108 s'étend de façon continue et sur toute la face supérieure de la couche 106.

Les couches 104, 106 et 108 sont par exemple réalisées par épitaxie. Bien que cela ne soit pas représenté en figure 10, une couche intermédiaire en nitrure d'aluminium peut être intercalée entre les couches 104 et 106. Le cas échéant, cela permet de favoriser l'épitaxie de la couche 106 en nitrure d'aluminium-gallium sur la couche 104 en nitrure de gallium par adaptation de paramètre de maille.

En figure 10, le gaz d'électrons bidimensionnel 2DEG s'étend latéralement et de façon continue dans la couche 104, sous l'interface entre les couches 104 et 106.

La figure 11 est une vue en coupe, schématique et partielle, illustrant une autre étape du mode de mise en œuvre du procédé de réalisation du transistor 900 de la figure 9.

Au cours de cette étape, on réalise une tranchée 1102 s'étendant verticalement en direction du substrat 102 depuis la face supérieure 108T de la couche 108 (réalisée par exemple en nitrure de silicium ou en nitrure de gallium). Plus précisément, dans l'exemple représenté, la tranchée 1102 traverse les couches 108 et 106 et pénètre partiellement dans l'épaisseur de la couche 104. La tranchée 1102 s'arrête dans la couche 104 et n'atteint pas la face supérieure 102T du substrat 102.

À titre d'exemple, la tranchée 1102 est réalisée par gravure de couches atomiques (« Atomic Layer Etching » - ALE, en anglais).

Selon un mode de mise en œuvre, on fait en sorte que la tranchée 1102 présente des parois latérales 1102L et 1102R, ou flancs, obliques. Plus précisément, on grave par exemple la tranchée 1102 de sorte que ses parois latérales 1102L et 1102R forment chacune un angle α par rapport à une normale à la face supérieure 108T de la couche 108. À titre d'exemple, l'angle α formé par les parois 1102L et 1102R est compris entre 5° et 45°, par exemple égal à environ 10°.

Les parois latérales 1102L et 1102R sont inclinées de manière à ce que la tranchée 1102 présente un profil évasé. Plus précisément, on fait en sorte que la tranchée 1102 présente une ouverture (en haut, dans l'orientation de la figure 11) plus large que son fond 1102B (en bas, dans l'orientation de la figure 11).

Les parois latérales 1102L et 1102R de la tranchée 1102 constituent des flancs de la future région 110G de grille du transistor 900. Plus précisément :
- la paroi 1102L constitue le flanc de la région 110G de grille situé côté électrode 112S de source ; et
- la paroi 1102R, opposée à la paroi 1102L, constitue le flanc de la région 110G de grille situé côté électrode 112D de drain.

Le fait de prévoir une tranchée 1102 présentant des parois latérales 1102L et 1102R obliques permet, lorsque le transistor 900 est à l'état passant, de faciliter le passage des électrons autour de la région 110G de grille. Cela permet, plus précisément, de faciliter la descente des électrons le long du flanc de la région 110G de grille situé côté électrode 112S, c'est-à-dire parallèlement à la paroi 1102L de la tranchée 1102.

Le fait de prévoir des parois 1102L et 1102R obliques permet en outre de réduire la longueur du chemin de conduction 116B (figure 3) sous le fond de la région 110G de grille. On diminue ainsi la résistance Ron à l'état passant du transistor 900.

À titre d'exemple, la tranchée 1102 présente :
- une largeur maximale Lmax comprise entre 0,4 et 1 µm, par exemple égale à environ 0,5 µm ; et
- une largeur minimale Lmin comprise entre 0,2 et 0,4 µm, par exemple égale à environ 0,3 µm.

À l'issue de cette étape, le gaz d'électrons bidimensionnel 2DEG est discontinu. Plus précisément, la tranchée 1102 sépare le gaz d'électrons bidimensionnel 2DEG en deux parties situées de part et d'autre de la tranchée 1102. Les couches 106 et 108 sont en outre séparées chacune en deux parties de couches disjointes situées de part et d'autre de la tranchée 1102.

La figure 12 est une vue en coupe, schématique et partielle, illustrant encore une autre étape du mode de mise en œuvre du procédé de réalisation du transistor 900 de la figure 9.

Au cours de cette étape, l'épaisseur T2 du matériau conducteur 306 est déposée sur la structure du côté de la face 102T du substrat 102. Dans l'exemple représenté, le matériau conducteur 306 forme une couche conductrice continue 1202 revêtant la face supérieure 108T de la couche 108 ainsi que les parois latérales 1102L, 1102R et le fond 1102B de la tranchée 1102.

À titre d'exemple, la couche conductrice 1202 est réalisée par une technique de dépôt conforme, par exemple par dépôt chimique en phase vapeur (« Chemical Vapor Déposition » - CVD, en anglais). On évite ou on limite ainsi la présence de défauts cristallins à l'interface entre les couches 104 et 1202, ces défauts étant susceptibles de former des états pièges pour les électrons.

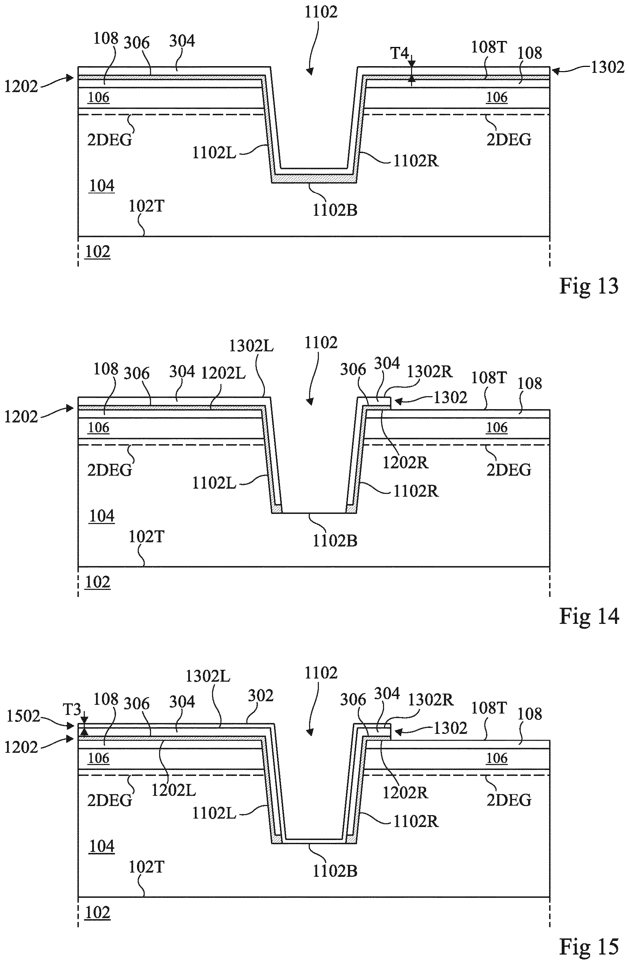

La figure 13 est une vue en coupe, schématique et partielle, illustrant encore une autre étape du mode de mise en œuvre du procédé de réalisation du transistor 900 de la figure 9.

Au cours de cette étape, l'épaisseur T4 du deuxième matériau isolant 304 est déposée sur la structure du côté de la face 102T du substrat 102. Dans l'exemple représenté, le matériau 304 forme une première couche isolante continue 1302. La couche isolante 1302 revêt la couche conductrice 1202.

La couche isolante 1302 est, par exemple, en alumine ou en silice. Dans le cas où la couche 1302 est en alumine, une couche en nitrure d'aluminium (AlN) peut être déposée sur la structure, du côté de la face supérieure 102T du substrat 102, préalablement à la réalisation de la couche 1302. Cela permet par exemple une meilleure adaptation de paramètre de maille entre les couches. On réduit ainsi le nombre de défauts susceptibles d'être présents à l'interface.

La figure 14 est une vue en coupe, schématique et partielle, illustrant encore une autre étape du mode de mise en œuvre du procédé de réalisation du transistor 900 de la figure 9.

Au cours de cette étape, la couche conductrice 1202 et la couche isolante 1302 sont gravées de sorte à exposer le fond 1102B de la tranchée 1102. On élimine pour cela des parties des couches 1202 et 1302 revêtant le fond 1102B de la tranchée 1102. Les couches 1202 et 1302 sont ainsi chacune séparées en deux parties disjointes.

On obtient plus précisément, à l'issue de la gravure :
- une partie 1202L de la couche conductrice 1202, située du côté de la paroi 1102L de la tranchée 1102 ;
- une autre partie 1202R de la couche conductrice 1202, située du côté de la paroi 1102R de la tranchée 1102 et isolée de la partie 1202L ;
- une partie 1302L de la couche isolante 1302, située du côté de la paroi 1102L de la tranchée 1102 ; et
- une autre partie 1302R de la couche isolante 1302, située du côté de la paroi 1102R de la tranchée 1102 et disjointe de la partie 1302L.

Dans l'exemple représenté, les couches 1202 et 1302 sont en outre gravées côté future électrode 112D (figure 9), c'est-à-dire à droite dans l'orientation de la figure 14, de sorte à exposer une partie de la face supérieure 108T de la couche 108 située entre la future électrode 112G et la future électrode 112D.

À titre d'exemple, les parties 1202L et 1202R de la couche conductrice 1202 et les parties 1302L et 1302R de la couche isolante sont réalisées par un procédé de gravure humide. Cela permet notamment d'obtenir une faible rugosité au niveau du fond 1102B de la tranchée 1102. On réduit ainsi la résistance Ron à l'état passant du transistor 900.

La gravure humide peut être précédée d'une étape de gravure sèche, par exemple assistée par plasma. Dans ce cas, la gravure humide permet une amélioration d'état de surface, obtenu à l'issue de l'étape de gravure sèche, du fond 1102B de la tranchée 1102.

À titre de variante, les couches 1202 et 1302 peuvent être gravées de sorte que les parties 1202L, 1202R, 1302L et 1302R se prolongent sur une partie du fond 1102B de la tranchée 1102. Dans ce cas, les parties 1202L et 1202R de la couche 1202 revêtent chacune partiellement le fond 1102B de la tranchée 1102 et les parties 1302L et les parties 1302L et 1302R de la couche 1302 s'étendent par exemple sur et en contact avec les parties 1202L et 1202R, respectivement.

On fait toutefois en sorte que les parties 1202L et 1202R de la couche conductrice 1202 soient disjointes. À titre d'exemple, on grave les couches 1202 et 1302 de manière que les parties 1202L, 1302L soient séparées des parties 1202R, 1302R par une distance suffisante pour éviter tout risque de claquage du fait de la polarisation de l'électrode 112D (figure 9) de drain du transistor 900. Cette distance est par exemple comprise entre 100 et 300 nm.

Le fait de prolonger les parties 1202L et 1202R de la couche 1202 sur le fond 1102B de la tranchée 1102 permet d'éviter ou de limiter l'apparition d'effets de bord tendant à accroître la résistance Ron à l'état passant du transistor 900.

La figure 15 est une vue en coupe, schématique et partielle, illustrant encore une autre étape du mode de mise en œuvre du procédé de réalisation du transistor 900 de la figure 9.

Au cours de cette étape, l'épaisseur T3 du premier matériau isolant 302 est déposée sur la structure du côté de la face 102T du substrat 102. Le matériau 302 est ensuite gravé pour ne conserver qu'une deuxième couche isolante 1502 revêtant les parties 1302L et 1302R de la première couche isolante 1302 et le fond 1102B de la tranchée 1102. Lors de l'opération de gravure, on retire plus précisément le matériau 302 revêtant la partie de la face supérieure 108T de la couche 108 située entre la future électrode 112G et la future électrode 112D.

On obtient ainsi avantageusement, le long de chaque paroi 1102L, 1102R de la tranchée 1102, une surépaisseur de matériau isolant par rapport au fond 1102B de la tranchée 1102.

À partir de la structure décrite en relation avec la figure 15, on réalise ensuite les électrodes 112S, 112G et 112D afin d'obtenir le transistor 900 exposé en relation avec la figure 9. À titre d'exemple, les électrodes 112S, 112G et 112D sont obtenues par dépôt puis gravure locale d'une couche métallique (non représentée) revêtant la face supérieure de la couche 1502 isolante et la partie exposée de la face supérieure 108T de la couche 108. L'électrode 112G de grille du transistor 900 (figure 9) est plus précisément formée à l'intérieur de la tranchée 1102, les flancs 118L et 118R de l'électrode 112G étant ainsi sensiblement parallèles aux parois 1102L et 1102R de la tranchée 1102.

Divers modes de réalisation et variantes ont été décrits. La personne du métier comprendra que certaines caractéristiques de ces divers modes de réalisation, modes de mise en œuvre et variantes pourraient être combinées, et d'autres variantes apparaîtront à la personne du métier.

À partir des indications ci-dessus, la personne du métier est notamment capable de prévoir :
- un transistor analogue au transistor 900 mais dépourvu de connexion entre l'électrode 112S de source et le matériau conducteur 306 côté flanc 118L de l'électrode 112G de grille ; et
- un autre transistor analogue au transistor 900 ou au transistor 700 mais dont le flanc 118R de l'électrode 112G de grille est revêtu du premier matériau isolant 302 et dépourvu du deuxième matériau isolant 304 et/ou du matériau conducteur 306, à l'instar du flanc 118R du transistor 300. Cet autre transistor peut en outre comporter une couche barrière arrière analogue à la couche 308 exposée en relation avec la figure 3.

La personne du métier est en outre capable de prévoir au moins un épaulement sur le flanc 118L et/ou sur le flanc 118R de l'électrode 112G de grille des transistors 300, 500, 700 et 900, par exemple un épaulement sur chaque flanc 118L, 118R. À titre d'exemple, cet épaulement est approximativement situé au niveau de la couche 106 de nitrure d'aluminium-gallium. Cela permet alors un lissage d'un champ électrique issu d'une polarisation de l'électrode 112D de drain par rapport à l'électrode 112G de grille. En d'autres termes, l'épaulement joue dans ce cas un rôle analogue à celui d'une plaque de champ (« field plate », en anglais). En variante, l'épaulement est situé dans l'épaisseur de la couche 104 en nitrure de gallium, de sorte à faciliter la circulation des électrons autour de la région 110G de grille ce qui permet de réduire encore davantage la résistance Ron à l'état passant du transistor.

L'adaptation du procédé de réalisation du transistor 900 décrit en relation avec les figures 10 à 15 afin d'obtenir les transistors 300, 500 et 700 des figures 3, 5 et 7 ainsi que les transistors des autres modes de réalisation et variantes des paragraphes ci-dessus, est également à la portée de la personne du métier.

Enfin, la mise en œuvre pratique des modes de réalisation, modes de mise en œuvre et variantes décrits est à la portée de la personne du métier à partir des indications fonctionnelles données ci-dessus. En particulier, la personne du métier est capable de choisir les matériaux 302, 304 et 306 et d'adapter les épaisseurs T1, T2, T3 et T4 en fonction de l'application visée.

## Revendications

1. Transistor (300 ; 500 ; 700 ; 900) comportant une couche (104) en nitrure de gallium dans laquelle pénètre partiellement une première électrode (112G) de grille dont :
- un premier flanc (118L, 118R) est revêtu :
d'une première épaisseur (T1) d'un premier matériau isolant (302) et d'un deuxième matériau isolant (304) ; et
d'une deuxième épaisseur (T2) d'un matériau conducteur (306) ; et
- un fond (118B) est revêtu d'une troisième épaisseur (T3), inférieure à la première épaisseur, du premier matériau isolant.

2. Transistor selon la revendication 1, comportant en outre des deuxième (112S) et troisième (112D) électrodes, situées de part et d'autre de la première électrode (112G) et pénétrant partiellement à l'intérieur de la couche (104) en nitrure de gallium, la deuxième électrode étant plus proche de la première électrode que la troisième électrode et le premier flanc (118L) étant situé du côté de la deuxième électrode.

3. Transistor selon la revendication 2, dans lequel le matériau conducteur (306) revêtant le premier flanc (118L) se prolonge jusqu'à la deuxième électrode (112S).

4. Transistor selon l'une quelconque des revendications 1 à 3, dans lequel le fond (118B) de la première électrode (112G) est séparé de la couche (104) en nitrure de gallium uniquement par la troisième épaisseur (T3) du premier matériau isolant (302).

5. Transistor selon l'une quelconque des revendications 1 à 4, dans lequel un deuxième flanc (118R) de la première électrode (112G), opposé au premier flanc (118L), est revêtu du premier matériau isolant (302), sur une épaisseur égale à la troisième épaisseur (T3).

6. Transistor selon l'une quelconque des revendications 1 à 4, dans lequel un deuxième flanc (118R) de la première électrode (112G), opposé au premier flanc (118L), est revêtu du premier matériau isolant (302) et du deuxième matériau isolant (304), sur une épaisseur égale à la première épaisseur (T1).

7. Transistor selon la revendication 5 ou 6, dans lequel le deuxième flanc (118R) est en outre revêtu du matériau conducteur (306), sur une épaisseur égale à la deuxième épaisseur (T2).

8. Transistor selon la revendication 7, dans lequel le matériau conducteur (306) revêtant le deuxième flanc (118R) est isolé du matériau conducteur (306) revêtant le premier flanc (118L).

9. Transistor selon l'une quelconque des revendications 1 à 8, dans lequel le deuxième matériau isolant (304) est identique au premier matériau isolant (302).

10. Transistor selon l'une quelconque des revendications 1 à 8, dans lequel le deuxième matériau isolant (304) est différent du premier matériau isolant (302).

11. Procédé de fabrication d'un transistor (300 ; 500 ; 700 ; 900) selon l'une quelconque des revendications 1 à 10, comprenant les étapes de :
a) former une tranchée (1102) à l'intérieur d'une couche (104) en nitrure de gallium ;
b) revêtir un premier flanc (1102L) de la tranchée d'une couche conductrice (1202) puis d'une première couche isolante (1302) ;
c) revêtir un fond (1102B) de la tranchée d'une deuxième couche isolante (1502), moins épaisse que la première couche isolante ; et
d) former une première électrode (112G) de grille du transistor à l'intérieur de la tranchée.

12. Procédé selon la revendication 11, dans lequel, à l'étape c), la première couche isolante (1302) est revêtue de la deuxième couche isolante (1502).

13. Procédé selon la revendication 11 ou 12, dans lequel, à l'étape c), un deuxième flanc (1102R) de la tranchée (1102), opposé au premier flanc (1102L), est revêtu de la deuxième couche isolante (1502).

14. Procédé selon la revendication 13, dans lequel, à l'étape b), le deuxième flanc (1102R) de la tranchée (1102) est revêtu de la couche conductrice (1202).

15. Procédé selon la revendication 14, dans lequel, à l'étape b), le deuxième flanc (1102R) de la tranchée est ensuite revêtu de la première couche isolante (1302).

16. Procédé selon l'une quelconque des revendications 11 à 15, comprenant en outre, entre les étapes b) et c), l'étape d'éliminer des parties de la première couche isolante (1302) et de la couche conductrice (1202) situées au fond (1102B) de la tranchée (1102).
